(19) Europäisches Patentamt
European Patent Office
Office européen des brevets

(11) **EP 2 523 223 A1**

(12) # EUROPEAN PATENT APPLICATION
published in accordance with Art. 153(4) EPC

(43) Date of publication:
**14.11.2012 Bulletin 2012/46**

(21) Application number: **11830818.8**

(22) Date of filing: **27.04.2011**

(51) Int Cl.:
*H01L 31/042* *(2006.01)*

(86) International application number:
**PCT/KR2011/003113**

(87) International publication number:
**WO 2012/046932 (12.04.2012 Gazette 2012/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.10.2010 KR 20100097056**

(71) Applicant: **LG Innotek Co., Ltd.**
**Seoul 100-714 (KR)**

(72) Inventor: **LEE, JinWoo**
**Seoul 100-714 (KR)**

(74) Representative: **Novagraaf Technologies**
**122 rue Edouard Vaillant**
**92593 Levallois-Perret Cedex (FR)**

(54) **SOLAR CELL AND METHOD FOR MANUFACTURING SAME**

(57)    Disclosed are a solar cell and a preparing method of the same. The solar cell includes a substrate, a back electrode layer on the substrate, a light absorbing layer on the back electrode layer, and a window layer on the light absorbing layer. The window layer includes a base layer on the light absorbing layer, and an anti-reflection pattern on the base layer. The anti-reflection pattern includes a top surface, and an inclined surface extending from the top surface in a direction in which the inclined surface is inclined with respect to the top surface.

Fig2

## Description

[Technical Field]

The embodiment relates to a solar cell and a preparing method of the same.

[Background Art]

Recently, as energy consumption is increased, a solar cell has been developed to convert solar energy into electrical energy.

In particular, a CIGS-based solar cell, which is a PN hetero junction apparatus having a substrate structure including a glass substrate, a metallic back electrode layer, a P type CIGS-based light absorbing layer, a high resistance buffer layer, and an N type window layer, has been extensively used.

[Disclosure]

[Technical Problem]

The embodiment provides a solar cell representing high light absorption efficiency and a preparing method of the same.

[Technical Solution]

According to the embodiment, there is provided a solar cell including a substrate, a back electrode layer on the substrate, a light absorbing layer on the back electrode layer, and a window layer on the light absorbing layer. The window layer includes a base layer on the light absorbing layer, and an anti-reflection pattern on the base layer. The anti-reflection pattern includes a top surface, and an inclined surface extending from the top surface in a direction in which the inclined surface is inclined with respect to the top surface.

According to the embodiment, there is provided a solar cell including a substrate, a back electrode layer on the substrate, a light absorbing layer on the back electrode layer, and a window layer on the light absorbing layer. The window layer includes a plurality of first grooves spaced apart from each other on a top surface, and a plurality of second grooves spaced apart from each other while crossing the first grooves.

According to the embodiment, there is provided a method of preparing a solar cell. The method includes forming a back electrode layer on a substrate, forming a light absorbing layer on the back electrode layer, forming a window layer on the light absorbing layer, forming a mask pattern on the window layer, and etching the window layer by using the mask pattern as an etching mask.

[Advantageous Effects]

As described above, according to the solar cell of the embodiment, a greater amount of light can be incident by using the anti-reflection pattern. In other words, the anti-reflection pattern decreases an amount of light reflected from the window layer and increases an amount of light incident into the light absorbing layer.

In particular, the anti-reflection pattern includes a flat top surface and an inclined surface. Therefore, the areas of the top surface of the anti-reflection pattern and the inclined surfaces can be suitably adjusted. In other words, the anti-reflection pattern can represent the optimal light incident rate by adjusting the areas of the top surface and the inclined surfaces of the anti-reflection pattern and adjusting the angle of the inclined surfaces.

Therefore, the solar cell according to the embodiment can represent improved optical characteristics and improved photoelectric conversion efficiency.

[Description of Drawings]

FIG. 1 is a perspective view showing a window layer of a solar cell according to the embodiment;
FIG. 2 is a sectional view showing the solar cell according to the embodiment;
FIG. 3 is a plan view showing an anti-reflection pattern; and
FIGS. 4 to 11 are sectional views showing the preparing process of the solar cell according to the embodiment.

[Best Mode]

In the description of the embodiments, it will be understood that when a substrate, a layer, a film or an electrode is referred to as being "on" or "under" another substrate, another layer, another film or another electrode, it can be "directly" or "indirectly" on the other substrate, the other layer, the other film, or the other electrode, or one or more intervening layers may also be present. Such a position of the layer has been described with reference to the drawings. The size of the elements shown in the drawings may be exaggerated for the purpose of explanation and may not utterly reflect the actual size.

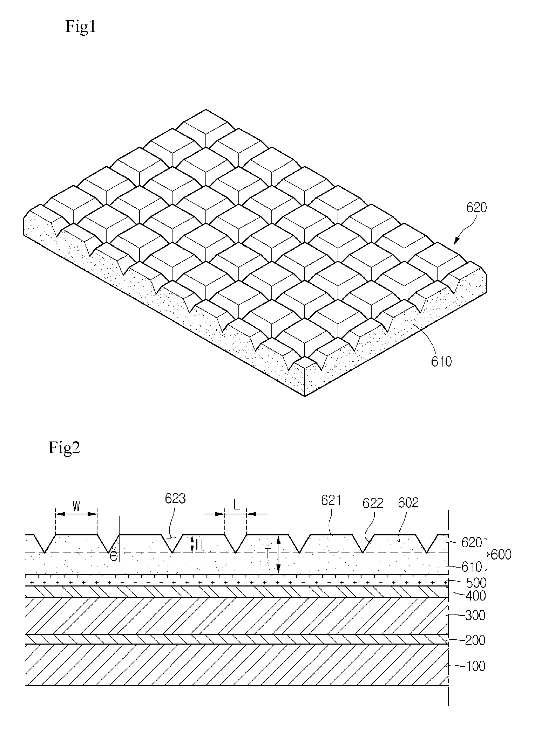

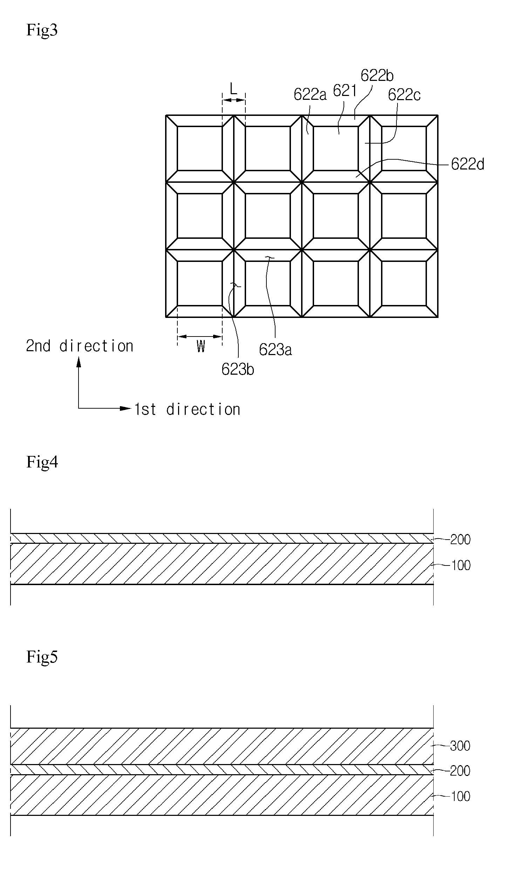

FIG. 1 is a perspective view showing a window layer of a solar cell according to the embodiment, FIG. 2 is a sectional view showing the solar cell according to the embodiment, and FIG. 3 is a plan view showing an anti-reflection pattern.

Referring to FIGS. 1 to 3, the solar cell includes a support substrate 100, a back electrode layer 200, a light absorbing layer 300, a buffer layer 400, a high resistance buffer layer 500, and a window layer 600.

The support substrate 100 has a plate shape and supports the back electrode layer 200, the light absorbing layer 300, the buffer layer 400, the high resistance buffer layer 500, and the window layer 600.

The support substrate 100 may include an insulator. The support substrate 100 may include a glass substrate, a plastic substrate, or a metallic substrate. In more detail, the support substrate 100 may include a soda lime glass substrate. The support substrate 100 may be transparent or may be rigid or flexible.

The back electrode layer 200 is provided on the substrate 100. The back electrode layer 200 may be a conductive layer. The back electrode layer 200 may include a metal, such as molybdenum (Mo).

In addition, the back electrode layer 200 may include at least two layers. In this case, the layers may be formed by using the homogeneous metal or heterogeneous metals.

The light absorbing layer 300 is provided on the back electrode layer 200. The light absorbing layer 300 includes a group I-III-VI compound. For example, the light absorbing layer 300 may have a $Cu(In,Ga)Se_2$ (CIGS) crystal structure, a $Cu(In)Se_2$ crystal structure, or a $Cu(Ga)Se_2$ crystal structure.

The light absorbing layer 300 has an energy bandgap in the range of about 1eV to about 1.8eV.

The buffer layer 400 is provided on the light absorbing layer 300. The buffer layer 400 directly makes contact with the light absorbing layer 300. The buffer layer 400 includes CdS and has an energy bandgap in the range of about 2.2eV to about 2.4eV.

The high resistance buffer layer 500 is provided on the buffer layer 400. The high resistance buffer layer 500 includes zinc oxide (i-ZnO) which is not doped with impurities. The energy bandgap of the high resistance buffer layer 500 may be in the range of about 3.1eV to about 3.3eV.

The window layer 600 is provided on the light absorbing layer 300. In more detail, the window layer 600 is provided on the high resistance buffer layer 500. The window layer 600 is transparent, and includes a conductive layer. In addition, the window layer 600 may include an Al doped zinc oxide (AZO).

The window layer 600 includes a base layer 610 and an anti-reflection pattern 620.

The base layer 610 is provided on the light absorbing layer 300. In more detail, the base layer 610 is provided on the high resistance buffer layer 500. The base layer 610 may cover the whole surface of the high resistance buffer layer 500. The thickness of the base layer 610 may be greater than 1/2 of the thickness of the window layer 600.

The anti-reflection pattern 620 is provided on the base layer 610. The anti-reflection pattern 620 is integrally formed with the base layer 610. The height of the anti-reflection pattern 620 may be smaller than 1/2 of the thickness of the window layer 600. In other words, the height H of the anti-reflection pattern 620 may be smaller than the thickness of the base layer 610.

The anti-reflection pattern 620 is a protrusion pattern. In other words, the anti-reflection pattern 620 includes a plurality of protrusions 602 protruding from the base layer 610.

Each protrusion 602 includes a top surface 621 and a plurality of inclined surfaces 622. In more detail, each protrusion 602 includes the top surface 621 and four inclined surfaces 622.

The top surface 621 of each protrusion 602 extends in the direction the same as the extension direction of the top surface of the light absorbing layer 300. In other words, the top surface 621 of each protrusion 602 may be substantially parallel to the top surface of the light absorbing layer 300. In addition, the top surface 621 of each protrusion 602 extends in a direction the same as extension directions of the top surface of the support substrate 100, the top surface of the back electrode layer 200, and the top surface of the high resistance buffer layer 500.

The top surface 621 of each protrusion 602 may have a polygonal shape. In detail, the top surface 621 of the protrusion 602 may have a quadrangular shape. In more detail, the top surface 621 of the protrusion 602 may have a rectangular shape. In still more detail, the top surface 621 of the protrusion 602 may have a square shape.

The inclined surfaces 622 of each protrusion 602 extend downward from the top surface 621. In more detail, the inclined surfaces 622 of the protrusion 602 extend toward the base layer 610 from the top surface 621. In other words, the inclined surfaces 622 are inclined with respect to the top surface 621.

For example, the inclined surfaces 622 may include first to fourth inclined surfaces 622a, 622b, 622c, and 622d. In this case, the second inclined surface 622b is adjacent to the first and third inclined surfaces 622a and 622c, and the third inclined surface 622c is adjacent to the second and fourth inclined surfaces 622b and 622d. In addition, the fourth inclined surface 622d is adjacent to the first and third inclined surfaces 622a and 622c. Further, the first and third inclined surfaces 622a and 622c face each other, and the second and fourth inclined surfaces 622b and 622d face each other.

An angle θ of the inclined surfaces 622 satisfies the following equation with respect to a direction perpendicular to the top surface 621 of the protrusion 602.

$$Equation$$

$$\theta < \tan^{-1}(L/T)$$

In the Equation, L refers to a distance between top surfaces 621 of adjacent protrusions 602, and T refers to a thickness of the window layer 600.

The protrusions 602 may have the shape of the shape of a truncated pyramid. In detail, the protrusions 602 may have the shape of a polygonal truncated pyramid. In more detail, the protrusions 602 may have the shape of a quadrangular truncated pyramid shape.

A width W of the top surface 621 of each protrusion 602 may be in the range of about 0.5μm to about

1.5μm. A distance L between the top surfaces 621 of the protrusion 602 may be in the range of about 0.5μm to about 4μm. A height H of the anti-reflection pattern 620 may be in the range of about 0.5μm to about 1μm.

Although the anti-reflection pattern 620 has been described in terms of a protrusion pattern, the anti-reflection pattern 620 may be described in terms of a groove pattern 623. In other words, the anti-reflection pattern 620 may be the groove pattern 623 formed by etching a portion of the window layer 600.

In this case, the groove pattern 623 includes a plurality of first grooves 623a extending in a first direction and a plurality of second grooves 623b extending in a second direction. In this case, the first and second grooves 623a and 623b cross each other. In more detail, the first grooves 623a and the second grooves 623b cross each other while representing the form of a mesh.

In addition, the grooves 623a are spaced apart from each other. Each first groove 623a includes first and second inner lateral sides inclined with respect to the top surface of the light absorbing layer 300. In this case, the first and second inner lateral sides make contact with each other. In other words, a sectional surface of the first grooves 623a may have the shape of a V. In other words, the first and second inner lateral sides are substantially identical to the second and fourth inclined surfaces 622b and 622d.

Further, the grooves 623b are spaced apart from each other. Each second groove 623b includes third and fourth inner lateral sides inclined with respect to the top surface of the light absorbing layer 300. In this case, the third and fourth inner lateral sides make contact with each other. In other words, a sectional surface of the first grooves 623a and the second grooves 623b may have a V shape. In other words, the third and fourth inner lateral sides are substantially identical to the first and fourth inclined surfaces 622a and 622c.

The protrusions 602 are defined by the first and second grooves 623a and 623b. Therefore, each of the first and second grooves 623a and 623b has an entrance width equal to the distance between the top surfaces 621 of the protrusions 602. In addition, each of the first and second grooves 623a and 623b has a depth equal to the height H of the protrusions 602.

The solar cell according to the embodiment can receive a greater amount of light incident thereon by employing the anti-reflection pattern 620. In other words, the anti-reflection pattern 620 decreases the amount of the light reflected from the window layer 600 and increases the amount of the light incident onto the light absorbing layer 300.

In particular, the areas of the top surface 621 and the inclined surface 622 of the anti-reflection pattern 620 can be suitably adjusted. In other words, the area of each of the top surface 621 and the inclined surface 622 of the anti-reflection pattern 620 can be adjusted, and the angle of the inclined surface 622 can be adjusted so that the anti-reflection pattern 620 can represent the optimal light incident rate.

Accordingly, the solar cell according to the embodiment can represent improved optical characteristics while representing improved photoelectric conversion efficiency.

FIGS. 4 to 7 are sectional surfaces showing the preparing process to prepare the solar cell according to the embodiment. Hereinafter, the present preparing method will be described by making reference to the above description of the solar cell. The description of the preparing method may be incorporated with the above description of the solar cell.

Referring to FIG. 4, the back electrode layer 200 is formed by depositing a metal such as molybdenum (Mo) on the support substrate 100 through a sputtering process. The back electrode layer 200 may be formed through two processes having process conditions different from each other.

An additional layer such as an anti-diffusion layer may be interposed between the support substrate 100 and the back electrode layer 200.

Referring to FIG. 5, the light absorbing layer 300 is formed on the back electrode layer 200.
The light absorbing layer 300 may be formed through a sputtering process or an evaporation scheme.

For example, the light absorbing layer 300 may be formed through various schemes such as a scheme of forming a Cu(In,Ga)Se$_2$ (CIGS) based light absorbing layer 400 by simultaneously or separately evaporating Cu, In, Ga, and Se and a scheme of performing a selenization process after a metallic precursor layer has been formed.

Regarding the details of the selenization process after the formation of the metallic precursor layer, the metallic precursor layer is formed on the back electrode layer 200 through a sputtering process employing a Cu target, an In target, a Ga target or an alloy target.

Thereafter, the metallic precursor layer is subject to the selenization process so that the Cu (In, Ga) Se$_2$ (CIGS) based light absorbing layer 300 is formed.

In addition, the sputtering process employing the Cu target, the In target, and the Ga target and the selenization process may be simultaneously performed.

Further, a CIS or a CIG based light absorbing layer 300 may be formed through the sputtering process employing only Cu and In targets or only Cu and Ga targets and the selenization process.

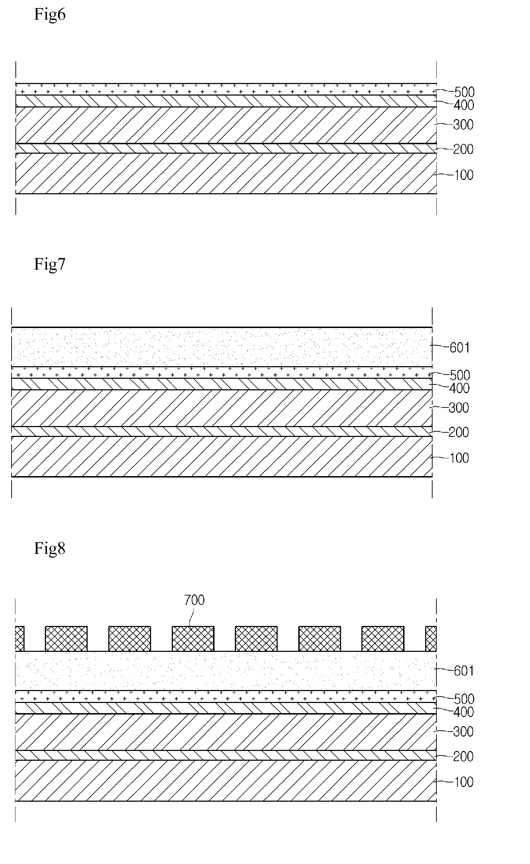

Referring to FIG. 6, the buffer layer 400 and the high resistance buffer layer 500 are formed on the light absorbing layer 300.

The buffer layer 400 may be formed through a chemical bath deposition (CBD) process. For example, after the light absorbing layer 300 has been formed, the light absorbing layer 300 is dipped into a solution including materials constituting CdS, and the buffer layer 400 including CdS is formed on the light absorbing layer 300.

Thereafter, the high resistance buffer layer 500 is formed by depositing zinc oxide on the buffer layer 400 through a sputtering process.

Referring to FIG. 7, the window layer 600 is formed on the high resistance buffer layer 500. In order to form the window layer 600, a transparent conductive layer 601 is formed by laminating a transparent conductive material on the high resistance buffer layer 500. The transparent conductive material may include an Al doped zinc oxide, indium zinc oxide (IZO), or indium tin oxide (ITO).

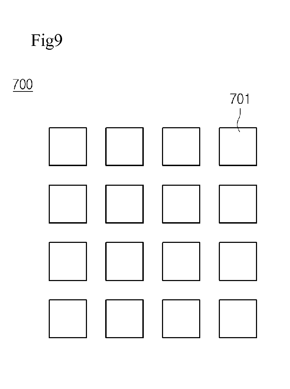

Referring to FIGS. 8 and 9, a mask pattern 700 is formed on the transparent conductive layer 601. The mask pattern 700 may be formed through a photolithography process. For example, a photoresist film is formed by coating photoresist resin on the transparent conductive layer 601. The mask pattern 700 may be formed by exposing and etching a portion of the photoresist film.

The mask pattern 700 has the shape of an island. In other words, the mask pattern 700 includes a plurality of masks 701 having the shape of an island. In this case, the masks 701 are spaced apart from each other. In addition, the masks 701 may be arranged in the form of a matrix.

Each mask 701 may have a width of about 1 $\mu$m, and the interval between the masks 701 may be about 3 $\mu$m.

The mask pattern 700 may include a silicon oxide or a silicon nitride. The mask pattern 700 has a thickness of about 1 $\mu$m.

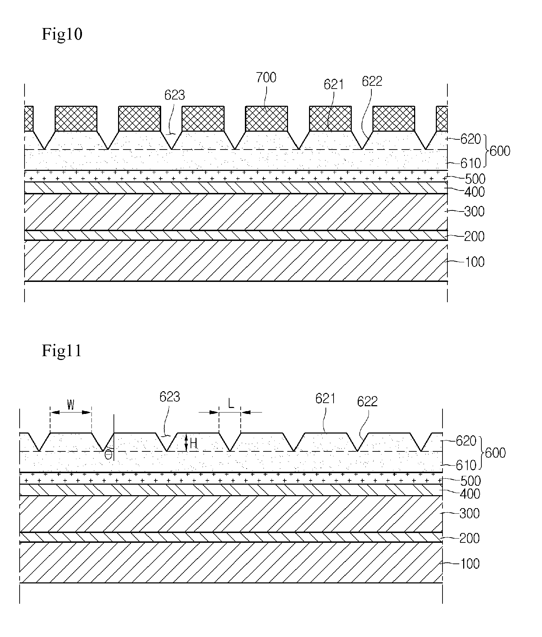

Referring to FIGS. 10 and 11, the transparent conductive layer 601 is etched by using the mask pattern 700 as an etching mask. In this case, the transparent conductive layer 601 is patterned through a wet etching process or a dry etching process.

Therefore, the transparent conductive layer 601 without the mask pattern 700 is etched while being inclined.

Therefore, the window layer 600 including the base layer 610 and the anti-reflection pattern 620 is formed on the light absorbing layer 300. Thereafter, the mask pattern 700 is removed.

The first grooves 623a and the second grooves 623b are formed in the transparent conductive layer 601 through the etching process, and the anti-reflection pattern 620 is defined by the first grooves 623a and the second grooves 623b. The inner lateral sides of the first and second grooves 623a and 623b are inclined with respect to the top surface of the light absorbing layer 300.

In this case, the etching depth of the transparent conductive layer 601 may be smaller than 1/2 of the thickness of the transparent conductive layer 601. In other words, the depth of the first and second grooves 623a and 623b may be smaller than 1/2 of the thickness of the transparent conductive layer 601.

As described above, according to the preparing method of the solar cell of the embodiment, the solar cell representing improved light incident rate can be easily prepared.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effects such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

[Industrial Applicability]

The solar cell and the preparing method of the same according to the embodiment are applicable for the field of solar light generation.

## Claims

1. A solar cell comprising:

   a substrate;
   a back electrode layer on the substrate;
   a light absorbing layer on the back electrode layer; and
   a window layer on the light absorbing layer,
   wherein the window layer comprises:

   a base layer on the light absorbing layer; and
   an anti-reflection pattern on the base layer, and

   wherein the anti-reflection pattern comprises:

   a top surface; and
   an inclined surface extending from the top surface in a direction in which the inclined surface is inclined with respect to the top surface.

2. The solar cell of claim 1, wherein the inclined surface comprises:

a first inclined surface;
a second inclined surface adjacent to the first inclined surface;
a third inclined surface adjacent to the second inclined surface; and
a fourth inclined surface adjacent to the first and third inclined surfaces.

3. The solar cell of claim 1, wherein the top surface has a polygonal shape.

4. The solar cell of claim 1, wherein the anti-reflection pattern has a height smaller than a thickness of the base layer.

5. The solar cell of claim 1, wherein the anti-reflection pattern is integrally formed with the base layer, and has a quadrangular truncated pyramid shape.

6. The solar cell of claim 1, wherein the top surface of the anti-reflection pattern has a width in a range of about 0.5μm to about 1.5μm.

7. The solar cell of claim 1, wherein the anti-reflection pattern comprises:

a first protrusion protruding upward from the base layer; and
a second protrusion adjacent to the first protrusion,
wherein an angle θ of the inclined surface about a direction perpendicular to the top surface of the anti-reflection pattern satisfies Equation 1,

$$\text{Equation 1}$$

$$\theta < \tan^{-1}(L/T),$$

in which L refers to a distance between a top surface of the first protrusion and a top surface of the second protrusion, and T refers to a thickness of the window layer.

8. The solar cell of claim 1, wherein the top surface of the anti-reflection pattern extends in a direction identical to an extension direction of a top surface of the light absorbing layer.

9. The solar cell of claim 8, wherein the top surface of the anti-reflection pattern is substantially parallel to the top surface of the light absorbing layer.

10. A solar cell comprising:

a substrate;
a back electrode layer on the substrate;
a light absorbing layer on the back electrode layer; and
a window layer on the light absorbing layer, wherein the window layer comprises:

a plurality of first grooves spaced apart from each other on a top surface; and
a plurality of second grooves spaced apart from each other while crossing the first grooves.

11. The solar cell of claim 10, wherein each first groove comprises:

a first inner lateral side inclined with respect to a top surface of the light absorbing layer; and
a second inner lateral side inclined with respect to the top surface of the light absorbing layer, and
wherein the first inner lateral side makes contact with the second inner lateral side.

12. The solar cell of claim 11, wherein each second groove comprises:

a third inner lateral side inclined with respect to the top surface of the light absorbing layer; and
a fourth inner lateral side inclined with respect to the top surface of the light absorbing layer, and
wherein the third inner lateral side makes contact with the fourth inner lateral side.

13. The solar cell of claim 10, wherein the first and second grooves have a V shape.

14. A method of preparing a solar cell, the method comprising:

forming a back electrode layer on a substrate;
forming a light absorbing layer on the back electrode layer;
forming a window layer on the light absorbing layer;
forming a mask pattern on the window layer; and
etching the window layer by using the mask pattern as an etching mask.

15. The method of claim 14, wherein the mask pattern has an island shape.

16. The method of claim 14, wherein, in the etching of the window layer, an etching depth of the window layer is smaller than 1/2 of a thickness of the window layer.

17. The method of claim 14, wherein the mask pattern has a quadrangular shape.

Fig1

Fig2

Fig3

2nd direction

1st direction

Fig4

Fig5

Fig6

```
+ + + + + + + + + + + + + + + + + + + + + + + + + + ——500
                                                    ——400
                                                    ——300
                                                    ——200
                                                    ——100
```

Fig7

```
                                                    ——601
+ + + + + + + + + + + + + + + + + + + + + + + + + + ——500
                                                    ——400
                                                    ——300
                                                    ——200
                                                    ——100
```

Fig8

```
                    700
                                                    ——601
+ + + + + + + + + + + + + + + + + + + + + + + + + + ——500
                                                    ——400
                                                    ——300
                                                    ——200
                                                    ——100
```

Fig9

700

701

Fig10

Fig11

## INTERNATIONAL SEARCH REPORT

| | International application No. |
|---|---|
| | **PCT/KR2011/003113** |

| A. CLASSIFICATION OF SUBJECT MATTER |
|---|
| *H01L 31/042(2006.01)i* |
| According to International Patent Classification (IPC) or to both national classification and IPC |

| B. FIELDS SEARCHED |
|---|
| Minimum documentation searched (classification system followed by classification symbols) |
| H01L 31/042; H01L 31/04 |
| Documentation searched other than minimum documentation to the extent that such documents are included in the fields searched<br>Korean Utility models and applications for Utility models: IPC as above<br>Japanese Utility models and applications for Utility models: IPC as above |
| Electronic data base consulted during the international search (name of data base and, where practicable, search terms used)<br>eKOMPASS (KIPO internal) & Keywords: anti-reflective, window layer, CIGS |

| C. DOCUMENTS CONSIDERED TO BE RELEVANT |
|---|

| Category* | Citation of document, with indication, where appropriate, of the relevant passages | Relevant to claim No. |
|---|---|---|
| X | KR 10-2010-0030137 A (INDUSTRY-ACADEMIC COOPERATION FOUNDATION, YEUNGNAM UNIVERSITY) 18 March 2010<br>See figure 2 and paragraph [0045]. | 1-17 |
| A | JP 06-209114 A (SANYO ELECTRIC CO LTD) 26 July 1994<br>See abstract and figures 4-5. | 1-17 |
| A | KR 10-2010-0033177 A (SAMSUNG ELECTRONICS CO., LTD.) 29 March 2010<br>See abstract and figure 1. | 1-17 |

| ☐ Further documents are listed in the continuation of Box C. | ☒ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 29 DECEMBER 2011 (29.12.2011) | **02 JANUARY 2012 (02.01.2012)** |

| Name and mailing address of the ISA/KR<br>Korean Intellectual Property Office<br>Government Complex-Daejeon, 139 Seonsa-ro, Daejeon 302-701,<br>Republic of Korea<br>Facsimile No. 82-42-472-7140 | Authorized officer<br><br><br>Telephone No. |
|---|---|

Form PCT/ISA/210 (second sheet) (July 2009)

INTERNATIONAL SEARCH REPORT
Information on patent family members

International application No.

**PCT/KR2011/003113**

| Patent document cited in search report | Publication date | Patent family member | Publication date |
|---|---|---|---|
| KR 10-2010-0030137 A | 18.03.2010 | NONE | |
| JP 06-209114 A | 26.07.1994 | JP 3442418 B2 | 02.09.2003 |
| KR 10-2010-0033177 A | 29.03.2010 | US 2010-0071764 A1 | 25.03.2010 |

Form PCT/ISA/210 (patent family annex) (July 2009)